# EUROPÄISCHE PATENTSCHRIFT

(11) **EP 0 976 185 B1**
(45) Veröffentlichungstag und Bekanntmachung des Hinweises auf die Patenterteilung: **06.04.2005**
(21) Anmeldenummer: 98966832.2
(22) Anmeldetag: 18.12.1998
(51) Int. Cl.: H01S 5/42, G02B 27/09

(54) **OPTISCHE ANORDNUNG ZUR SYMMETRIERUNG DER STRAHLUNG EINES ODER MEHRERER ÜBEREINANDER ANGEORDNETER HOCHLEISTUNGSDIODENLASER**
OPTICAL SYSTEM FOR SYMMETRISING THE BEAM OF ONE OR MORE SUPERIMPOSED HIGH-POWER DIODE LASERS
SYSTEME OPTIQUE PERMETTANT DE RENDRE SYMETRIQUE LE RAYONNEMENT D'AU MOINS UNE DIODE-LASER HAUTE PUISSANCE SUPERPOSEES

(30) Priorität: 09.01.1998 DE 19800590
(43) Veröffentlichungstag der Anmeldung: 02.02.2000
(73) Patentinhaber: JENOPTIK Aktiengesellschaft, 07743 Jena (DE)
(72) Erfinder: GÖRING, Rolf, D-07749 Jena (DE); SCHREIBER, Peter, D-07749 Jena (DE); HEINEMANN, Stefan, Ann Arbor, MI 48105 (US); RÖLLIG, Ulrich, D-07747 Jena (DE); NICKEL, Michael, D-07743 Jena (DE)
(74) Vertreter: Bertram, Helmut, Dipl.-Phys.
(86) Internationale Anmeldenummer: PCT/EP1998/008316
(87) Internationale Veröffentlichungsnummer: WO 1999/035724

(56) Entgegenhaltungen:
- WO-A-96/21877
- DE-A- 19 645 150
- GOERING R ET AL: "MICROOPTICAL BEAM TRANSFORMATION SYSTEM FOR HIGH-POWER LASER DIODE BARS WITH EFFICIENT BRIGHTNESS CONSERVATION" PROCEEDINGS OF THE SPIE, Bd. 3008, Nr. 18, 10. Februar 1997, Seiten 202-210, XP002057348

## Beschreibung

Die Erfindung bezieht sich auf eine Anordnung zur Symmetrierung der Strahlung von einem oder mehreren Hochleistungsdiodenlasern zum Zwecke der Erzielung hoher Leistungsdichten bei gleichzeitig hoher Strahlqualität entsprechend dem Oberbegriff des Patentanspruches 1.

Die Abstrahleigenschaften von Hochleistungsdiodenlasern (Diodenlaser mit mehreren in einer Reihe angeordneten Emittern oder Emittergruppen) (im folgenden HL-DL genannt) sind hinreichend oft beschrieben worden. Die Besonderheit ergibt sich bei HL-DL in der Tatsache der stark unterschiedlichen Divergenz der emittierenden Strahlung und der räumlichen Ausdehnung der Emitteranordnung in einer Ebene parallel und senkrecht zum pn-Übergang.
So beträgt die Divergenz in der Ebene des pn-Übergangs (im folgenden fast axis) etwa 45 Grad FHWM und in der Ebene senkrecht zum pn-Übergang (im folgenden slow axis) etwa 10 Grad FHWM
Bei typischen Maßen für einen Emitter von ca. 1 µm Höhe x 200 µm Breite ergibt sich beispielsweise bei einer Reihe von 25 Emittern, die einen Abstand von ca. 200 µm zueinander aufweisen, ein Strahlungsfeld von 1 µm Höhe und 10 mm Breite. Die emittierende Strahlung ist über die Breite des Strahlungsfeldes inhomogen, d.h. sie besteht aus mehreren Strahlungsbündeln, bestimmt durch Anzahl, Abstand und Breite der Emitter. Für die beispielhaft angeführte Emitteranordnung ergeben sich 25 Strahlungsbündel mit einer Strahlaustrittsöffnung von 1 µm x 200 µm.
Zum Zwecke der Symmetrierung der Strahlung können diese Strahlenbündel im Komplex, in Gruppen zusammengefaßt oder auch einzeln geformt werden.

Alle bekannten optischen Anordnungen zur Symmetrierung der Strahlung von HL-DL weisen in Richtung der Strahlausbreitung und von der HL-DL ausgehend, als erstes optisches Element jeweils eine, einer Emitterreihe vorgeordnete Zylinderlinse zur Kollimation der Strahlung in fast axis Richtung auf.
Nachfolgend werden unterschiedliche Kombinationen optischer Elemente und Baugruppen angeordnet mit dem Ziel, eine Homogenisierung der stark unterschiedlichen Strahlqualitäten der beiden Ebenen zu realisieren.

Derartige Anordnungen sind aus WO 96/13884, DE 196 45 150 und DE 195 00 513 bekannt. Die beiden erstgenannten Lösungen haben den Nachteil, daß die Anzahl der HL-DL, deren Strahlung in die Anordnung geeignet abgebildet werden kann, eng begrenzt ist, wodurch die erreichbare Gesamtleistung des HL-DL auf etwa 100 W beschränkt ist.
Für HL-DL mit einer großen Anzahl von Emittern, vornehmlich für mehrere übereinander angeordneter HL-DL, ist die in der DE 195 00 513 vorgestellte Anordnung anwendbar. Diese Anordnung erlaubt durch die Strahlformung sehr vieler Emitter eine Skalierung zu sehr hohen Leistungen. Bei der in der DE 195 00 513 beschriebenen Anordnung wird zuerst, wie bekannt, die Strahlung jedes einzelnen HL-DL in Richtung der fast axis mittels einer Zylinderlinse auf wenige mrad Restdivergenz kollimiert.
In Richtung der slow axis ist die Strahlung aufgrund der Aneinanderreihung von mehreren einzelnen Emittern bzw. Emittergruppen, wie bereits erwähnt, keine homogene Linienstahlquelle.
Da sich Linienstrahlquellen um so besser mit einer optischen Anordnung kollimieren oder fokussieren lassen, je kleiner die Ausdehnung der Linienquelle ist, ist es von Vorteil, die Strahlenbündel der einzelnen Emitter bzw. Emittergruppen in slow axis Richtung einzeln zu kollimieren.
Zu diesem Zweck wird in der DE 195 00 513 jeweils einer Zylinderlinse ein Prismensystem nachgeordnet, um die in Richtung der fast axis kollimierten Strahlung benachbarter Emitter bzw. Emittergruppen in fast axis Richtung umzulenken. Die so umgelenkten Teilbündel bleiben in Richtung der slow axis zueinander versetzt. Dadurch können die den einzelnen Strahlenbündeln zugeordneten Zylinderlinsenelemente eines segmentierten Kollimationslinsensystems zur Kollimation der Strahlung in Richtung der slow axis, bezüglich der slow axis überlappend angeordnet werden. Hierdurch können auch bei kleinen Abständen zwischen den Emittern bzw. Emittergruppen einer HL-DL durch Verwendung größerer Kollimationslinsen die Beugungsverluste minimiert werden. Es wird eine gute Strahlformung in Richtung der slow axis ermöglicht, jedoch bedingt das segmentierte Zylinderlinsensystem einen erheblichen Realisierungsaufwand.
Die Strahlqualität der durch die beschriebene Umlenkung separierten Einzelbündel bestimmt entscheidend die Strahlqualität der gesamten optischen Anordnung.
Das optische System nach DE 195 00 513 führt jedoch keine optimale Umordnung der Strahlenbündel aus Sicht der Strahlqualität durch:
- Der ursprüngliche Versatz der separierten Einzelbündel entlang der slow axis bleibt erhalten und es findet keine Symmetrierung der Strahlqualität durch Umordnung in den beiden Achsrichtungen statt. Hierdurch ist die Strahlqualität, d.h. die erreichbare minimale Fokusgröße bzw. die numerische Apertur der Gesamtstrahlung bei Austritt aus der Anordnung nach unten systemtechnisch begrenzt.
- Außerdem wird ein sehr hoher Aufwand bei der Strahlformung in Richtung der slow axis durch Einfügen eines segmentierten Kollimationslinsensystems betrieben.

Aufgabe der vorliegenden Erfindung ist es, eine neue einfachere optische Anordnung aufzuzeigen, welche für die Strahlung eines oder mehrerer HL-DL neben einer effizienten Strahlformung auch eine Strahlumordnung derart durchführt, daß eine Symmetrierung der Strahlqualität in slow und fast axis vor der Fokussierung erreicht wird, wodurch die Strahlqualität im Fokus erheblich verbessert wird.

Diese Aufgabe wird mit einer optischen Anordnung gemäß Anspruch 1 erfüllt. Vorteilhafte Ausführungsformen sind in den Unteransprüchen dargestellt.

Erfindungswesentlich ist, daß die Strahlenbündel der einzelnen Emitter oder Emittergruppen jedes einzelnen HL-DL durch optisch beugende, reflektierende oder brechende Mittel so umgelenkt werden, daß sie sich in Richtung der slow axis überlagern, so daß sie mit einer einzelnen Zylinderlinse in Richtung der slow axis kollimiert werden können und eine weitgehende Symmetrierung der gesamten Strahlung erreicht wird.

Die erfindungsgemäße Anordnung wird im folgenden an Hand der Zeichnung näher beschrieben. Dazu zeigt:
- Fig. 1: die vereinfachte Darstellung eines ersten Ausführungsbeispiels, geeignet für einen HL-DL mit drei Emittern bzw. Emittergruppen, in der Seitenansicht.
- Fig. 2: die Anordnung nach Fig. 1 in der Draufsicht
- Fig. 3: die vereinfachte Darstellung eines zweiten Ausführungsbeispiels, geeignet für drei übereinander angeordnete HL-DL, in der Seitenansicht

Als erstes Ausführungsbeispiel soll der Übersichtlichkeit halber eine erfindungsgemäße Anordnung beschrieben werden, die geeignet ist, die Strahlung eines HL-DL 1 mit drei Emittern bzw. Emittergruppen in einen Punkt zu fokussieren. Das Strahlungsfeld besteht demnach aus drei in slow axis nebeneinander angeordneten Emittern bzw. Emittergruppen 2a, 2b, 2c.

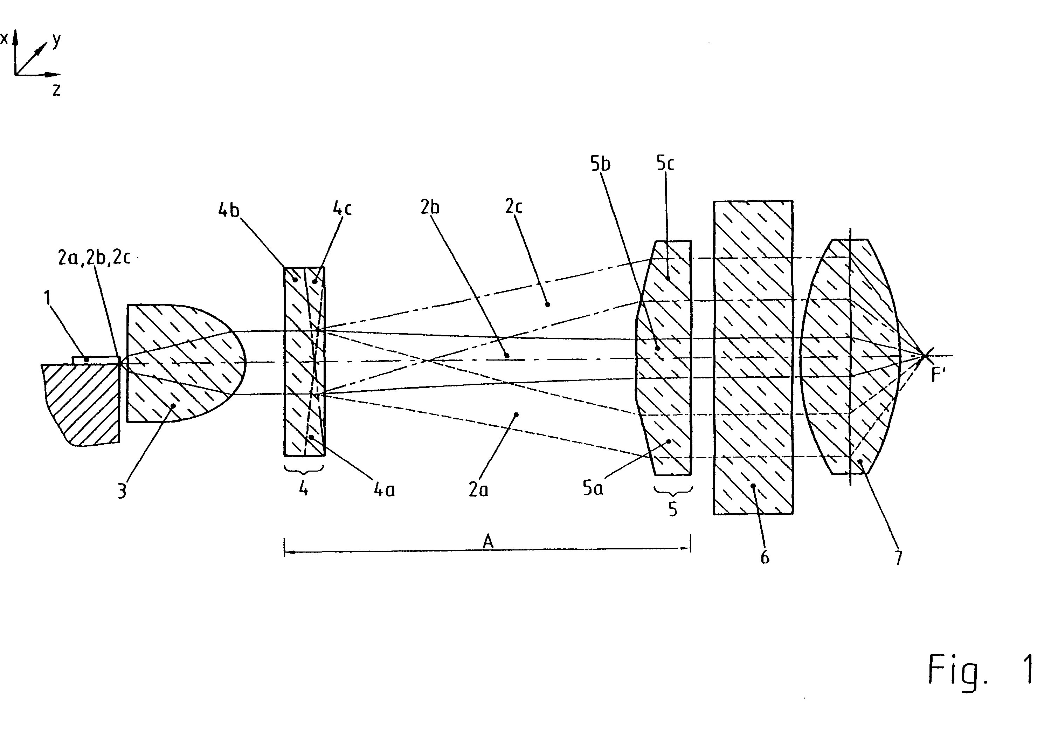

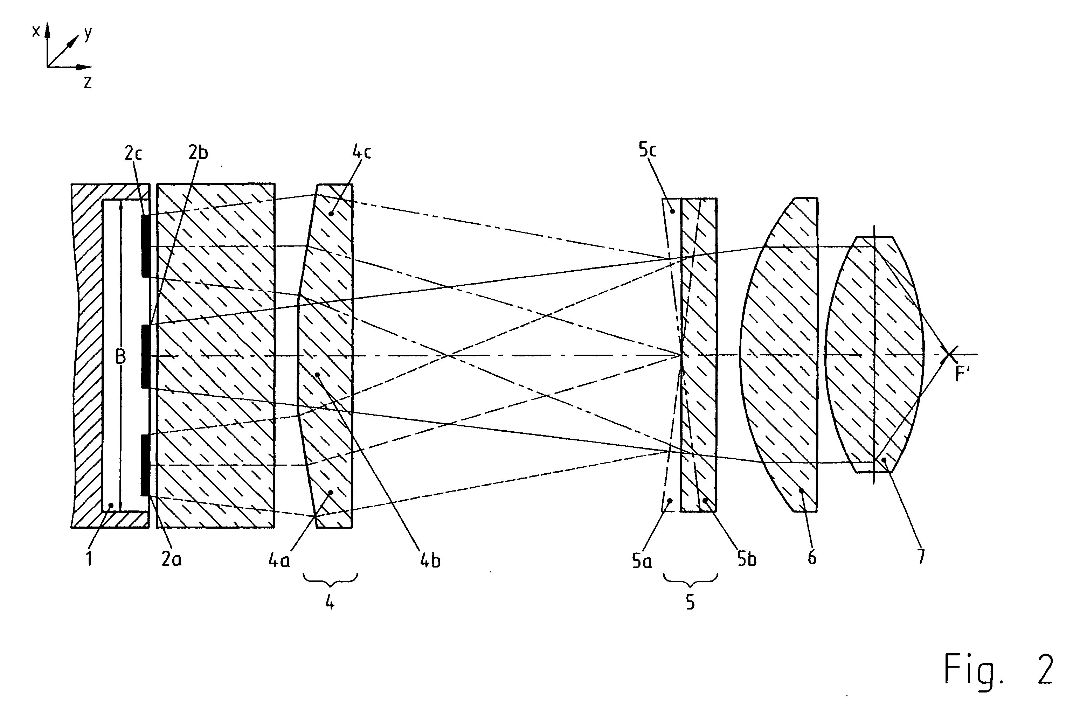

Wie aus Fig. 1 und Fig. 2 ersichtlich, umfaßt das erste Ausführungsbeispiel in folgender Reihenfolge, in Strahlungsrichtung dem HL-DL 1 angeordnet, folgende optische Funktionselemente:
eine erste Zylinderlinse 3, ein erstes ablenkendes Element, im weiteren als Direktionselement 4 bezeichnet, ein zweites ablenkendes Element, im weiteren als Redirektionselement 5 bezeichnet, eine zweite Zylinderlinse 6 und eine Fokussierlinse 7. Bis auf die Fokussierlinse 7, welche eine einfache plan-konvexe Linse sein kann, beeinflussen alle optischen Funktionselemente die Strahlung der Emitter bzw. der Emittergruppen 2a, 2b, 2c in Richtung der fast axis und der slow axis unterschiedlich. Die unterschiedliche Wirkungsweise der Anordnung auf die Strahlung ist in Fig. 1 in Richtung der fast axis (x-z Ebene, Seitenansicht) und in Fig. 2 in Richtung der slow axis (y-z Ebene, Draufsicht) an Hand des Strahlenverlaufes dargestellt.

Die in Fig.1 dargestellten, von den Emittern bzw. Emittergruppen 2a, 2b und 2c ausgesandten drei Strahlenbündel, werden als erstes in Richtung der fast axis in bekannter Weise durch eine erste Zylinderlinse 3 kollimiert. Nach dem Stand der Technik werden hierfür asphärische Zylinderlinsen eingesetzt, welche die Divergenz auf typisch 5 mrad reduzieren. Typische Durchmesser des Strahlenbündels betragen nach der Kollimation in fast axis Richtung 0.6 mm. In Richtung des slow axis hat diese erste Zylinderlinse 3 keine Wirkung.

Das Direktionselement 4 ist in einem minimal möglichen Abstand zur ersten Zylinderlinse 3 nachgeordnet und ist entlang der slow axis entsprechend den Emittern bzw. Emittergruppen 2a, 2b und 2c in drei unterschiedliche Segmente 4a, 4b, 4c derart unterteilt, daß die Strahlenbündel beim Durchtritt sowohl in Richtung der fast axis als auch der slow axis unterschiedlich abgelenkt werden, wie in Fig. 2 dargestellt. Dabei wird das Strahlenbündel des mittleren Emitters bzw. Emittergruppe 2b in keine Richtung abgelenkt. Die Ablenkung der Strahlung des Emitters bzw. der Emittergruppe 2a erfolgt um einen bestimmten Winkel in der y-Richtung zur Mitte hin und in der x-Richtung nach unten. Die Ablenkung der Strahlung des Emitters bzw. der Emittergruppe 2c erfolgt um die gleichen Beträge, aber in jeweils umgekehrter Richtung. Die Absolutwerte der Ablenkwinkel ergeben sich grundsätzlich aus den geometrischen Dimensionen der HL-DL, insbesondere der Breite B, die sich aus der Anzahl, dem Abstand und der Breite der einzelnen Emitter bzw. Emittergruppen eines HL-DL ergibt, dem Abstand P zwischen zwischen den Emittern bzw. Emittergruppen zweier gegebenenfalls übereinander angeordneter HL-DL, sowie dem axialen Abstand A zwischen dem Direktionselement 4 und dem Redirektionselement 5.
Bei der im Ausführungsbeispiel gewählten Anordnung der Emitter bzw. Emittergruppen 2a, 2b, 2c eines HL-DL sind die Ablenkwinkel des Direktionselementes 4 in Richtung der slow axis derart gewählt, daß sich in einem definierten Abstand A vom Direktionselement 4 die Hauptstrahlen der einzelnen Strahlenbündel in der Ebene des Redirektionselementes 5 schneiden. In Richtung der fast axis sind die Ablenkwinkel des Direktionselementes 4 derart gewählt, daß sich im Abstand A deutlich voneinander separierte Strahlenbündel ergeben.
Das Redirektionselement 5 besteht ebenfalls aus drei Segmenten, welche die jeweils hindurchtretenden Strahlenbündel so umlenken, daß exakt die im Direktionselement 4 erfahrene Ablenkung der Hauptstrahlen in x und y-Richtung kompensiert wird. Dies ist die Voraussetzung für eine optimale Fokussierbarkeit. Zur Fokussierung aller Strahlenbündel in einen möglichst kleinen Fleck sind nachfolgend eine in Richtung der slow axis wirkende zweite Zylinderlinse 6 und eine sphärische Fokussierlinse 7 im Strahlengang angeordnet. Durch das Direktionselement 4 und das Redirektionselement 5 werden die Strahlenbündel der einzelnen Emitter bzw. Emittergruppen 2a, 2b, 2c derart umgeordnet, daß sie nachfolgend nicht mehr in y-Richtung sondern in x-Richtung nebeneinander angeordnet sind. Dies führt zu einer bestmöglichen Symmetrierung der stark unterschiedlichen Strahlqualität der Strahlung von HL-DL in beiden Achsen. Damit ist die nachfolgende Strahlformung, sogar mit deutlich besserer Strahlqualität gegenüber dem Stand der Technik, mit einer einfachen zweiten Zylinderlinse 6, ohne den Einsatz eines segmentierten Kollimationslinsensystems, möglich. Die Brennweite der zweiten Zylinderlinse 6 ist so gewählt, daß die durch das Redirektionselement 5 hindurchtretende Strahlung in y-Richtung auf wenige mrad kollimiert wird.

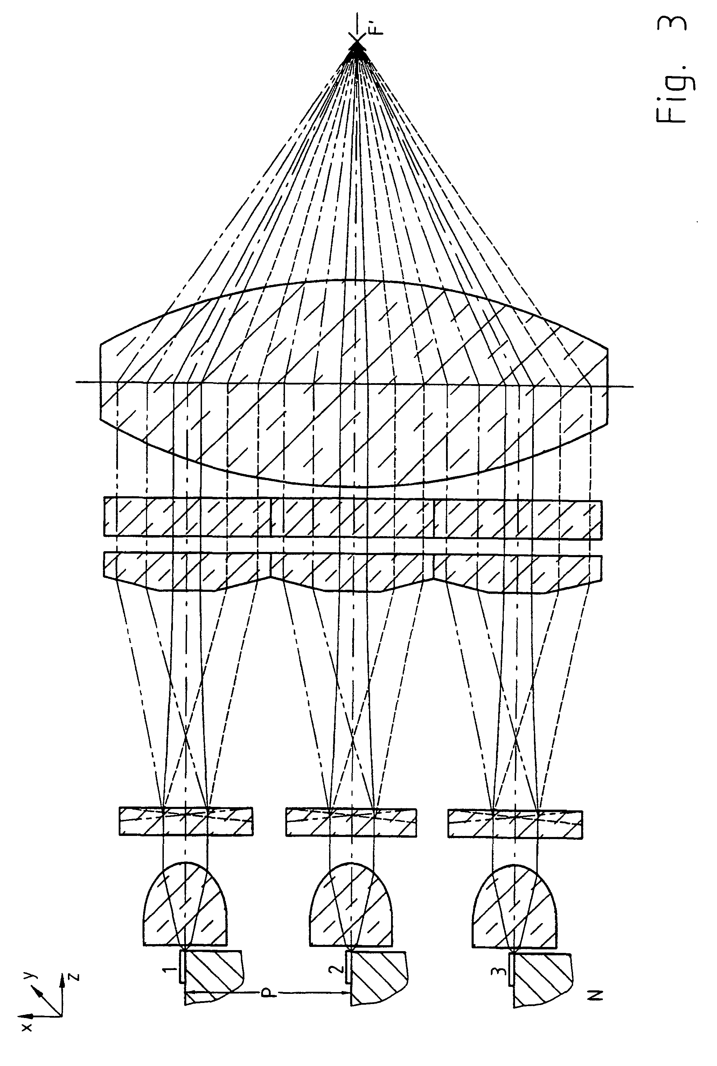

In einem zweiten Ausführungsbeispiel soll die erfindungsgemäße Anordnung für vierundzwanzig übereinander angeordnete HL-DL ausgelegt sein. In Fig. 3 ist dieses zweite Ausführungsbeispiel, reduziert auf die Darstellung der Strahlenbündel von drei HL-DL, in der Seitenansicht gezeigt. Die Emitter bzw. Emittergruppen zweier benachbarter HL-DL haben zueinander einen Abstand P.

Grundsätzlich wird die Ausführung der erfindungsgemäßen Anordnung und entsprechend die Anzahl der HL-DL von der gewünschten Leistung und Geometrie in dem Punkt, in welchem die Strahlung abgebildet werden soll, bestimmt. Bestimmend für die Leistung ist die Anzahl der übereinander angeordneten HL-DL. Die Strahlqualität hängt im wesentlichen von der Anzahl der Unterteilungen einer Emitterreihe in Emittergruppen ab, wobei die maximale Anzahl der Unterteilungen gleich der Anzahl der Emitter sein kann. Dies soll im folgenden an Hand des zweiten Ausführungsbeispieles beschrieben werden.

Das Ziel soll die Ausleuchtung eines rechteckförmigen Strahlflecks mit den Kantenlängen 2*4 mm² sein, wobei die numerische Apertur 0.1 in Richtung der fast axis und der slow axis nicht überschreiten soll.
Eine Kantenlänge von 4 mm kann durch drei in einer Reihe angeordnete Emittergruppen mit einer Breite von jeweils 3.3 mm und einer numerischen Apertur von 0.12 erreicht werden. Die optischen Funktionselemente werden nun in Richtung der slow axis so ausgelegt, daß sich im Fokus ein Strahlfleck mit einer Länge von 4 mm und einer numerischen Apertur von 0.1 ergibt. Zur Strahlformung werden eine Zylinderlinse und eine bikonvexe Fokussierlinse eingesetzt, deren Brennweiten sich zu etwa 260 mm ergeben, der Abstand zwischen Direktions- und Redirektionselement 4;5 liegt im Bereich um 60 mm.
Eine Kantenlänge von 2 mm Höhe kann mit einer numerischen Apertur von 0.1 realisiert werden. Basierend auf dem Abstand der Emittergruppen zweier benachbarter HL-DL von typisch 1.7 mm und einer Divergenz der in fast axis Richtung kollimierten Strahlung von typischerweise 5 mrad können so 24 HL-DL übereinander in Richtung der fast axis angeordnet werden, um die Leistung im Fokus zu skalieren. Jedem HL-DL, d.h. jeder Reihe von Emittergruppen wird eine erste Zylinderlinse 3 nachgeordnet. Das nachfolgende Direktionselement 4 wird in seiner x-Ausdehnung so gewählt, daß es eine Strahlumordnung für alle Reihen von Emittergruppen bewirkt. Das Redirektionselement 5 besteht für den beschriebenen Fall der dreifachen Segmentierung aus je drei Segmenten für je eine Reihe. Bei der im Ausführungsbeispiel gewählten Anordnung der Emittergruppen 2 und bei Vorgabe eines Abstandes P ergeben sich die Ablenkwinkel des Direktionselementes 4 in Richtung der slow axis (fast axis) zu arctan(B/3A) (arctan[P/3A]). Bei typischen Werten für B und P von 10 mm und 1,7 mm ergibt sich ein Verhältnis der Ablenkwinkel von etwa 6, bei typischen Werten für A von etwa 60 mm liegen diese dann um 3° bzw. 0,5°.

Die Funktion der Kollimation in Richtung der slow axis kann unabhängig von der Zahl der Emitterreihen von einer Einzellinse jedoch unterschiedlicher Länge erfüllt werden. Ebenso erfolgt die Fokussierung aller Strahlenbündel unabhängig von der Anzahl der Emitterreihen mit nur einer Fokussierlinse. Zum Zwecke der Anpassung der Höhe der Strahlenbündel in fast axis -Richtung am Ort des Redirektionselementes 5 an die Höhe der einzelnen Segmente 5a, 5b, 5c kann eine Refokussierung der Strahlenbündel in fast axis Richtung gewählt werden. Dies wird durch eine Verschiebung der Zylinderlinse 3 in z-Richtung erreicht. Ein durch die Refokussierung bewirkter stärkerer Astigmatismus kann durch die Anordnung eines Zylinderlinsenarrays unmittelbar vor oder hinter dem Direktionselement 5 kompensiert werden.
Für die im vorliegenden Fall der Dreiteilung und eines Abstandes P von typisch 1,7 mm wäre eine Refokussierung auf etwa 0.55 mm der Strahlenbündel in der Redirektionsebene 5 notwendig. Beim Einsatz verfügbarer Asphärenlinsen wäre eine solche Refokussierung selbst bei Linsendicken von 1,5 mm erreichbar

In den beiden Ausführungsbeispielen sind die Direktionselemente 4 und Redirektionselemente 5 der Einfachheit halber als transmitive Prismensysteme dargestellt. Es ist für den Fachmann klar, daß diese Elemente ebenso als reflektive Systeme auch anderer Struktur, z.B. fresnelsche Strukturen und diffraktive Strukturen, sein können. Alle Direktions- bzw. Redirektionselemente 4;5 können jeweils einzeln oder gemeinsam als Monolith oder Quasimonolith ausgeführt sein. Selbstverständlich können die einzelnen, die Strahlungen unterschiedlich ablenkenden Segmente des Direktions- bzw. des Redirektionselementes 4;5, auch selbständige optische Elemente sein. Der Aufwand zur Herstellung und Montage des optischen Systems ist gegenüber dem Stand der Technik erheblich reduziert, falls das Direktionselement 4 als Monolith ausgeführt ist oder die Funktionen des Direktionselements 4 und des Redirektionselementes 5 in einem optischen Element zusammengefaßt sind und dieses als Monolith ausgeführt ist.

## Patentansprüche

1. Optische Anordnung zur Symmetrierung der Strahlung eines oder mehrerer übereinander angeordneter Hochleistungsdiodenlaser HL-DL (1) zum Zwecke der Fokussierung in einen Punkt, wobei ein Hochleistungsdiodenlaser (1) mehrere in einer Reihe angeordnete Emitter bzw. Emittergruppen (2) aufweist, jeder Reihe eine erste Zylinderlinse (3) zur Kollimation der Strahlenbündel der Emitter bzw. Emittergruppen (2) in Fast-Axis-Richtung senkrecht zu der Ebene des pn-Übergang der Emitter und ein Direktionselement (4) mit einer Anzahl unterschiedlicher Segmente gleich der Anzahl der Emitter bzw. Emittergruppen (2), welche die Strahlenbündel in Fast-Axis-Richtung durch Beugung, Brechung oder Reflexion umlenken, nachgeordnet sind. Mittel zur Kollimation der Strahlenbündel in Slow-Axis-Richtung parallel zu der Ebene des pn-Übergang der Emitter und eine die gesamte Strahlung in einen Punkt fokussierende Linse (7) vorhanden sind, wobei der Fokus auf der optischen Achse liegt, welche als die Senkrechte zur Slow-Axis-Richtung und zur Fast-Axis-Richtung definiert ist, **dadurch gekennzeichnet,**
**daß** die Mittel zur Kollimation der Strahlenbündel in Slow-Axis-Richtung eine einzige zweite Zylinderlinse (6) sind,
**daß** die Segmente des Direktionselementes (4) die Strahlenbündel in Slow-Axis-Richtung jeweils so zueinander umlenken, daß sich ihre Hauptstrahlen in einem Abstand A zum Direktionselement (4) in Slow-Axis-Richtung mit der optischen Achse überlagern und in Fast-Axis-Richtung in gleichen Abständen übereinander angeordnet sind, und
**daß** im Abstand A jedem Direktionselement (4) ein Redirektionselement (5) nachgeordnet ist, welches die Strahlenbündel so umlenkt, daß sie parallel zueinander verlaufen.

2. Optische Anordnung nach Anspruch 1, **dadurch gekennzeichnet,**
**daß** zur Anpassung des Abstandes der Hochleistungsdiodenlaser (1) entlang der Fast-Axis-Richtung die ersten Zylinderlinsen (3) eine Zwischenfokussierung in die Redirektionsebene bewirken.

3. Optische Anordnung nach Anspruch 2, **dadurch gekennzeichnet,**
**daß** ein Zylinderlinsenarray unmittelbar vor oder hinter dem Redirektionselement (5) angeordnet ist, welches den durch die Zwischenfokussierung bewirkten stärkeren Astigmatismus kompensiert.

4. Optische Anordnung nach Anspruch 1 oder 2, **dadurch gekennzeichnet,**
**daß** durch die Strahlumordnung die Strahlung des Hochleistungsdiodenlasers (1) in der slow-Axis-Richtung mindestens halbiert, vorzugsweise gedrittelt wird und somit nach dem Direktionselement (4) in der Fast-Axis-Richtung mindestens zwei, vorzugsweise wenigstens drei parallel in der Fast-Axis-Richtung versetzte Strahlenbündel austreten.

5. Optische Anordnung nach den Ansprüchen 1 oder 2, **dadurch gekennzeichnet,**
**daß** bei Anordnung mehrerer HL-DL die Anzahl der Segmentierung der Direktionselemente (4) und Redirektionselemente (5) an den Abstand P der HL-DL zueinander derart angepaßt ist, daß beschränkt durch die Restdivergenz der Strahlenbündel in der Fast-Axis-Richtung eine möglichst hohe Symmetrierung der Strahlqualitäten in beiden Ebenen erfolgt.

6. Optische Anordnung nach Anspruch 1, **dadurch gekennzeichnet,**
**daß** das jeweils einem HL-DL nachgeordnete Direktionselement (4) und Redirektionselement (5) als Monolith ausgeführt sind.

7. Optische Anordnung nach Anspruch 1, **dadurch gekennzeichnet,**
**daß** alle Direktionselemente (4) als ein Monolith ausgeführt sind.

8. Optische Anordnung nach Anspruch 1, **dadurch gekennzeichnet,**
**daß** alle Redirektionselemente (5) als ein Monolith ausgeführt sind.

## Claims

1. An optical arrangement for symmetrization of radiation from one or more superimposed high-power diode lasers HL-DL (1) for the purpose of focusing in one point, wherein one high-power diode laser (1) comprises a plurality of emitters or groups of emitters (2) arranged in a row,
there being arranged, following each row, a first cylindrical lens (3) for collimation of the ray bundle from the emitters or groups of emitters (2) in a fast-axis direction, perpendicular to the plane of the p-n junction of the emitters, and a directing element (4) comprising a number of different segments equal to the number of emitters or groups of emitters (2), said segments defecting the ray bundles in the fast-axis direction by diffraction, refraction or reflection,
there being provided means for collimating the ray bundles in a slow-axis direction, parallel to the plane of the p-n junction of the emitters, and a lens (7), which focuses the entire radiation in one point, with the focus being located on the optical axis which is defined as the normal to the slow-axis direction and to the fast-axis direction, **characterized in that**
the means for collimating the ray bundles in the slow-axis direction are a single second cylindrical lens (6),
**in that** the segments of the directing element (4) respectively deflect the ray bundles relative to each other in the slow-axis direction such that their principal rays are superimposed on the optical axis at a distance A from the directing element (4) in the slow-axis direction and are arranged above each other at equal distances in the fast-axis direction, and
**in that** each directing element (4) has a redirecting element (5) arranged following it at the distance A, said redirecting element (5) deflecting the ray bundles such that they extend parallel to each other.

2. Optical arrangement according to claim 1, **characterized in that**,
in order to adapt the distance of the high-power diode laser (1) along the fast-axis direction, the first cylindrical lenses (3) cause intermediate focusing in the plane of redirection.

3. Optical arrangement according to claim 2, **characterized in that**
a cylindrical lens array is arranged directly in front of or behind the redirecting element (5), said cylindrical lens array compensating for the stronger astigmatism caused by said intermediate focusing.

4. Optical arrangement according to claim 1 or 2, **characterized in that**,
due to the ray rearrangement, the radiation from the high-power diode laser (1) in the slow-axis direction is divided at least by two, preferably by three, and thus at least two, preferably at least three ray bundles with a parallel off-set in the fast-axis direction exit following the directing element (4) in the fast-axis direction.

5. Optical arrangement according to any one of claims 1 or 2, **characterized in that**,
when arranging a plurality of HL-DLs, the number of segments of the directing elements (4) and of the redirecting elements (5) is adapted to the distance P of the HL-DLs relative to each other such that, restricted by the residual divergence of the ray bundles in the fast-axis direction, symmetrising of the ray qualities is effected to the highest possible extent in both planes.

6. Optical arrangement according to claim 1, **characterized in that** each directing element (4) and each redirecting element (5) arranged following an HL-DL is provided as a monolith.

7. Optical arrangement according to claim 1, **characterized in that** all directing elements (4) are provided as a monolith.

8. Optical arrangement according to claim 1, **characterized in that** all redirecting elements (5) are provided as a monolith.

## Revendications

1. Un arrangement optique pour la symétrisation du rayonnement d'un ou plusieurs lasers à diode de haute puissance HL-DL (1), disposés les uns au-dessus des autres, à des fins de focalisation dans un point, dans lequel arrangement un laser à diode de haute puissance (1) comporte plusieurs émetteurs ou groupes d'émetteurs (2) disposés en série,
et à chaque série succèdent une première lentille cylindrique (3) pour la collimation du faisceau de rayons qui vient des émetteurs ou groupes d'émetteurs (2), dans une direction d'axe rapide, perpendiculaire au plan du jonction p-n des émetteurs, et un élément de direction (4) comportant un nombre de segments différents qui est égal au nombre des émetteurs ou groupes d'émetteurs (2), lesdits segments défléchissant les faisceaux de rayons dans la direction d'axe rapide par diffraction, réfraction ou réflexion,
des moyens étant présents pour collimater les faisceaux de rayons dans une direction d'axe lente, qui est parallèle au plan du jonction p-n des émetteurs, ainsi qu'une lentille (7) qui focalise tout le rayonnement dans un point, le point focal étant situé sur l'axe optique qui est défini comme étant la verticale à la direction d'axe lente et à la direction d'axe rapide, ledit arrangement étant **caractérisé en ce que**
les moyens pour collimater les faisceaux de rayons dans une direction d'axe lente sont une seule seconde lentille cylindrique (6),
**en ce que** chacun des segments de l'élément de direction (4) défléchit respectivement les faisceaux de rayons, les uns par rapport aux autres, dans la direction d'axe lente de sorte que leur rayons principaux soient superposés à l'axe optique à une distance A de l'élément de direction (4) dans la direction d'axe lente et soient disposés les uns sur les autres à distances égales dans la direction d'axe rapide, et
**en ce qu'**à chacun des éléments de direction (4) succède un élément de redirection (5) à une distance A, ledit élément de redirection (5) défléchissant les faisceaux de rayons de sorte qu'ils soient parallèles les uns aux autres.

2. Arrangement optique selon la revendication 1, **caractérisé en ce que**,
afin d'adapter la distance du laser à diode de haute puissance (1) selon la direction d'axe rapide, les premières lentilles cylindriques (3) effectuent une focalisation intermédiaire au plan de rédirection.

3. Arrangement optique selon la revendication 2, **caractérisé en ce qu'**un
groupement de lentilles cylindriques précède ou succède directement à l'élément de redirection (5), ledit groupement de lentilles cylindriques compensant l'astigmatisme élevé résultant de ladite focalisation intermédiaire.

4. Arrangement optique selon la revendication 1 ou 2, **caractérisé en ce que**,
à cause du réarrangement des rayons, le rayonnement du laser à diode de haute puissance (1) dans la direction d'axe lente est divisé en au moins deux parties, de préférence en trois parties, et ainsi, au moins deux, de préférence trois, faisceaux de rayons, qui sont déplacés en parallèle dans la direction d'axe rapide, sortent derrière l'élément de direction (4) dans la direction d'axe rapide.

5. Arrangement optique selon l'une quelconque des revendications 1 ou 2, **caractérisé en ce que**,
en disposant plusieurs HL-DL, le nombre de segments des éléments de direction (4) et des éléments de redirection (5) est adapté à la distance P entre les HL-DL de manière que, limité par la divergence résiduelle des faisceaux de rayons dans la direction d'axe rapide, une symétrisation maximale des qualités des rayons est effectuée aux deux plans.

6. Arrangement optique selon la revendication 1, **caractérisé en ce que** chaque élément de direction (4) et chaque élément de redirection (5) succédant à un HL-DL est sous forme d'un monolithe.

7. Arrangement optique selon la revendication 1, **caractérisé en ce que** tous les éléments de direction (4) sont sous forme d'un monolithe.

8. Arrangement optique selon la revendication 1, **caractérisé en ce que** tous éléments de redirection (5) sont sous forme d'un monolithe.
